# EUROPEAN PATENT APPLICATION

(11) **EP 2 728 822 A2**
(43) Date of publication of application: **07.05.2014**
(21) Application number: 13188452.0
(22) Date of filing: 14.10.2013
(51) Int. Cl.: H04L 27/06

(54) **Demodulation apparatus and method for operating the same**

(30) Priority: 31.10.2012 KR 20120122641
(71) Applicant: LSIS Co., Ltd., Dongan-gu, Anyang-si Gyeonggi-do 431-848 (KR)
(72) Inventor: Chung, Chel Ho, Gyeonggi-do (KR); Kim, Young-Han, Seoul (KR)
(74) Representative: Tholén, Johan

(57) **Abstract**

A demodulation apparatus comprises: an envelope detecting unit configured to receive a signal from the outside and detect an envelope signal from the received signal; a reference voltage generating unit configured to generate a reference voltage on the basis of the detected envelope signal; a comparator configured to output a pulse signal on the basis of the envelope signal detected by the envelope detecting unit and the reference voltage generated by the reference voltage generating unit; and an input signal adjusting unit connected with an envelope signal input terminal of the comparator to selectively adjust a magnitude of the envelope signal input to the comparator.

## Description

### BACKGROUND OF THE INVENTION

### 1. Field of the Invention

The present disclosure relates to a demodulation apparatus, and more particularly, to a demodulation apparatus for demodulating signals having various input power levels and modulation index, and a method for operating the same.

### 2. Background of the Invention

In general, a demodulation apparatus serves to receive a modulated radio frequency (abbreviated as RF hereinafter) signal and restores it into the original frequency signal. In particular, the typical radio frequency identification (abbreviated as RFID hereinafter) technology using an RF signal reads out information from a tag having unique identification information or write information to the tag in a non-contacting manner, whereby article or animals having tags attached thereto may be recognized, tracked, or managed.

Namely, an RFID technology refers to a technology for recognizing information from a remote area by using radio waves. In order to implement such an RFID technology, an RFID tag and an RFID reader are required. The aforementioned RFID tag includes an antenna and an integrated circuit (abbreviated as IC hereinafter), and in this case, information is written in the IC and transmitted to the reader through the antenna.

Such information is used to identify a target having a tag attached thereto, and has a function similar to that of a bar code. However, RFID is different from a bar code system, in that it reads information by using electric waves, rather than using light. Thus, a tag may be read from a distant area, rather than being operated only within a short distance like a bar code reader, and information may be received even through an object present between articles.

As mentioned above, an RFID system using RFID technology includes a plurality of electronic tags (or transponders) having unique identification information and attached to articles, animals, and the like, and an RFID reader (or an interrogator) for reading information from a tag or writing information into a tag.

In this case, an RFID system may be classified into a mutual induction type RFID system and an electromagnetic wave type RFID system according to a mutual communication scheme between a reader and a tag, may be classified into an active RFID system and a passive RFID system according to whether a tag is operated by self-power, and may be classified into a long-wave RFID system, a medium-wave RFID system, a short-wave RFID system, an ultrashort-wave RFID system, and a micro-wave RFID system according to a frequency in use.

An RFID that reads information of a chip and performs communication only with electric power of a reader is known as a passive RFID. In case of a semi-passive RFID, a tag includes a battery installed therein, and thus, power of the battery is used to read information of a chip and power of a reader is used to perform communication. In case of an active RFID, power of a tag is used to read information of a chip and transmit and receive the information.

Also, an RFID system may be classified according to a frequency of radio waves used for communication, instead of power. An RFID using a low frequency is known as low-frequency identification (abbreviated as LFID), which uses radio waves ranging from 120 to 140 KHz.

High frequency identification (abbreviated as HFID) uses 13.56 MHz, while ultrahigh-frequency identification (abbreviated as UHFID) uses radio waves having a band ranging from 868 to 956 MHz.

The RFID technology has been utilized in various fields. Namely, it is extensively used to record scores of athletes, trace production history, and attach a tag to a passport, an identification card, or the like, to include personal information therein and recognize it.

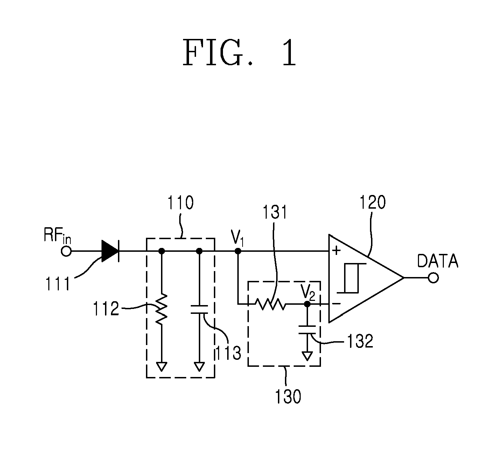

FIG. 1 is a view illustrating a related art demodulation apparatus.

Referring to FIG. 1, a demodulation apparatus 100 includes an envelope detector 110, a comparator 120, and a low pass filter (abbreviated as LPF hereinafter) 130.

The envelope detector 110 includes a diode 111, a resistor 112, and a capacitor 113.

In the envelope detector 110, an amplitude shift keying (abbreviated as ASK hereinafter)-modulated signal is applied to an anode of the diode 111, and the resistor 112 and the capacitor 113 are connected in parallel to a cathode of the diode 111.

An output terminal of the envelope detector 110 is connected to one side of a differential input terminal of the comparator 120, and an output terminal of the LPF 130, including a resistor 131 connected in series to a capacitor 132 connected to a ground in parallel, is connected to the other end of the differential input terminal of the comparator 120.

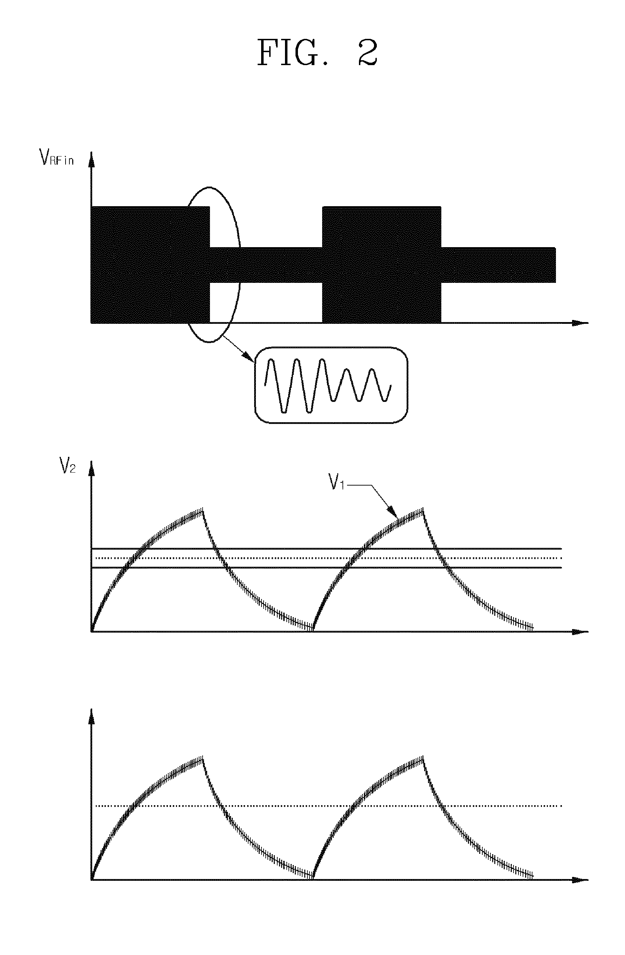

FIG. 2 is a view illustrating a flow of a demodulation signal based on FIG. 1.

Referring to FIG. 1, when an ASK-modulated signal is applied to the anode terminal of the diode 111, a high frequency component of the ASK-modulated signal is removed by the envelope detector 110 including the diode 111, the resistor 112, and the capacitor 113 to obtain a signal without a high frequency component.

In this case, the reason why the data signal does follow an envelope having an accurate square shape is because time constants of the resistor 112 and the capacitor 113.

The data signal is directly input to one side of the differential input terminal of the comparator 120 (V1), and a reference voltage V2 of the comparator 120 is generated through the LPF 130 including the resistor 131 and the capacitor 132 by using a different path.

Accordingly, the ASK-modulated signal components may be output as a digital signal.

Meanwhile, if a difference between a magnitude of maximum electric power and magnitude of minimum electric power of modulated signals applied to the demodulation apparatus 100 is significant, it may not be easy to determine values of the resistor 112 and the capacitor 113. Thus, when the demodulation apparatus 100 is designed by determining values of the resistors 112 and 131 and the capacitors 113 and 132 on the basis of a signal having a low level of electric power, if the reference voltage in the node V2 has a form similar to that of the signal in the node V1, rather than having a direct current (DC) form, in case of applying a high electric power signal, there may be a high possibility that a signal having a desired level of electric power is not normally demodulated.

For example, when this concept is applied to a 900 MHz RFID tag system, a reader is required to output signal with 30dBm by including data therein, and in this case, when the reader is close to a tag, it should demodulate a signal having electric power ranging from 20 to 30 dBm. When values of the resistors 112 and 131 and the capacitors 113 and 132 are determined on the basis thereof, a high electric power input signal may be demodulated, but a chip size of the tag is increased and there is a limitation in a demodulation range when a low electric power signal is input.

Conversely, when a tag has good sensitivity, it may be read from a distance. Thus, when a demodulator is designed to be operated with 20 dBm or lower by increasing stage numbers of a voltage multiplier and adjusting values of a resistor and a capacitor, sensitivity of a tag can be enhanced and a chip size can be reduced. However, in a case in which a high power signal is applied, a signal having a high voltage level is filtered in the node V1, making it difficult to generate a reference voltage, and thus, it is difficult to demodulate a signal having a high range of electric power.

### SUMMARY OF THE INVENTION

Therefore, an aspect of the detailed description is to provide a demodulation apparatus capable of normally demodulating signals having various input electric power levels and modulation indexes, and a method for operating the same.

Another aspect of the detailed description is to provide a demodulation apparatus capable of demodulating all the signals having various modulation indexes ranging from 0% to 100%, thus being applied to various applications through a single information provider (abbreviated as IP hereinafter), and a method for operating the same.

To achieve these and other advantages and in accordance with the purpose of this disclosure, as embodied and broadly described herein, a demodulation apparatus comprising:
an envelope detecting unit configured to receive a signal from the outside and detect an envelope signal from the received signal;
a reference voltage generating unit configured to generate a reference voltage on the basis of the detected envelope signal;
a comparator configured to output a pulse signal on the basis of the envelope signal detected by the envelope detecting unit and the reference voltage generated by the reference voltage generating unit; and
an input signal adjusting unit connected with an envelope signal input terminal of the comparator to selectively adjust a magnitude of the envelope signal input to the comparator,
wherein the envelope signal detecting unit comprises: a voltage multiplying unit configured to multiply a voltage of the received signal; and a shunt resistor capacitor (RC) connected to an output terminal of the voltage multiplying unit to determine an RC time constant.

The input signal adjusting unit comprises a switch whose switching state is selectively changed to adjust a magnitude of the envelope signal.

The switch may be automatically biased according to a magnitude of the reference voltage input to the comparator to have a changed switching state.

When the reference voltage input to the comparator is higher than a predetermined operational voltage, the switch may be closed, and when the reference voltage input to the comparator is lower than the predetermined operational voltage, the switch may be opened.

The demodulation apparatus may further include a plurality of transistors for current mirroring and disposed in the envelope signal input terminal of the comparator, wherein the plurality of transistors are selectively connected to the envelope signal input terminal of the comparator according to a switching state of the switch.

The comparator comprises: a pair of differential input terminals configured to receive the reference voltage and the envelope signal, respectively, and a hysteresis circuit including a plurality of transistors cross-linked to the pair of differential input terminals.

The pair of differential input terminals comprises a first input terminal configured to receive the envelop signal and a second input terminal configured to receive the reference voltage, and the input signal adjusting unit may be disposed between the envelope signal detecting unit and the first input terminal of the comparator.

The voltage multiplying unit comprises a first voltage multiplying unit configured to receive the ASK-modulated signal and multiply the ASK-modulated signal to have a first voltage; and a second voltage multiplying unit configured to multiply the multiplied signal, which has been multiplied to have the first voltage, to have a second voltage, and output the same.

The voltage multiplying unit comprises: at least a pair of capacitos connected in series mutually to receive the signal; a plurality of N-channel Metal Oxide Semiconductor (abbreviated as NMOS hereinafter) transistors connected to the at least one capacitor; and at least one shunt capacitor connected to the plurality of NMOS transistors.

The reference voltage generating unit comprises: a voltage divider configured to divide the voltage of the detected envelope signal to generate a reference voltage signal; and a low pass filter (abbreviated as LPF hereinafter) configured to filter the generated reference voltage signal and output a reference voltage to be input to the comparator.

The envelope detecting unit may be configured to receive the ASK-modulated signal from at least one RFID reader positioned nearby.

The demodulation apparatus may further include: a voltage amplifying unit configured to amplify a voltage of a pulse signal output from the comparator, wherein the voltage amplifying unit comprises at least one P-channel Metal Oxide Semiconductor(abbreviated as PMOS hereinafter) transistor.

The demodulation apparatus may further include: a level shift circuit configured to receive the amplified pulse signal from the voltage amplifying unit and adjust a voltage level of the received pulse signal.

Further scope of applicability of the present application will become more apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from the detailed description.

### BRIEF DESCRIPTION OF THE DRAWINGS

The accompanying drawings, which are included to provide a further understanding of the invention and are incorporated in and constitute a part of this disclosure, illustrate exemplary embodiments and together with the description serve to explain the principles of the invention.

In the drawings:
FIG. 1 is a view illustrating a related art demodulation apparatus.
FIG. 2 is a view illustrating a flow of a demodulation signal based on FIG. 1.
FIG. 3 is a schematic block diagram of a demodulation apparatus according to an embodiment of the present invention.
FIG. 4 is a block diagram of a demodulation apparatus according to another embodiment of the present invention.
FIG. 5 is a circuit diagram illustrating a configuration of a voltage multiplier according to an embodiment of the present invention illustrated in FIG. 3 or 4.
FIG. 6 is a circuit diagram illustrating configurations of a shunt RC and a reference voltage generating unit according to an embodiment of the present invention illustrated in FIG. 3 or 4.
FIG. 7 is a circuit diagram illustrating a configuration of a comparator according to an embodiment of the present invention illustrated in FIG. 3 or 4.
FIGS. 8 and 9 are circuit diagrams specifically illustrating an overall configuration of the demodulation apparatus according to an embodiment of the present invention.
FIG. 10 is a flow chart illustrating an operating method of the demodulation apparatus according to an embodiment of the present invention.

### DETAILED DESCRIPTION OF THE INVENTION

The disclosure hereinafter simply exemplifies a principle of the present invention. Therefore, a person skilled in the art may implement the principle of the present invention and invent various devices included in the concept and scope of the present invention although not clearly described or illustrated in this disclosure. Also, it should be understood that the conditional terms and embodiments described herein are considered in a descriptive sense only and not for the purposes of limitation.

Also, it should be understood that all the detailed descriptions for specific embodiments, as well as the principle, perspectives, and embodiments, intentionally include structural and functional equivalents of such matters. Also, it should be understood that the equivalents include all the devices invented to perform the same functions irrespective of the equivalents, i.e., structures, to be developed in the future, as well as currently known equivalents.

Hereinafter, a demodulation apparatus capable of demodulating signals having various input power levels and demodulation indices and a method for operating the same will be described.

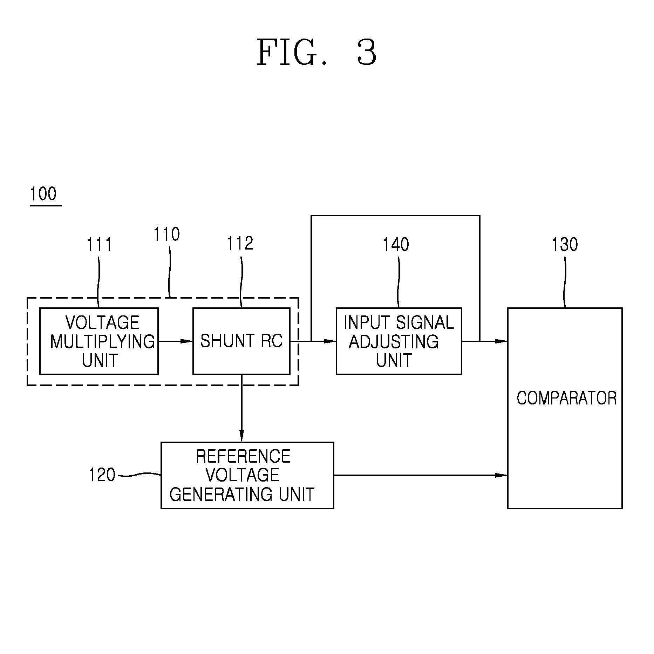

FIG. 3 is a schematic block diagram of a demodulation apparatus according to an embodiment of the present invention.

Referring to FIG. 3, a demodulation apparatus 100 according to an embodiment of the present invention comprises an envelope detecting unit 110 configured to receive a modulated signal and detect an envelope signal from the received modulated signal, a reference voltage generating unit 120 configured to generate a reference voltage on the basis of the detected envelope signal, a comparator 130 configured to compare the envelope signal with the reference voltage to generate a pulse signal, and an input signal adjusting unit 140 configured to selectively adjust a magnitude of the envelope signal input to the comparator 130.

The envelope detecting unit 110 comprises a voltage multiplier 111 configured to receive the modulated signal and multiply the received modulated signal to have a predetermined voltage and a shunt resistor capacitor (abbreviated as a shunt RC hereinafter) circuit section 112 connected to a rear stage of the voltage multiplier 111 to determine a resistor-capacitor(abbreviated as RC hereinafter) time constant.

The voltage multiplier 111 receives a signal from the outside (for example near RFID reader) and multiplies it to have a predetermined voltage. For example, the voltage multiplier 111 may receive a high frequency signal which has been coded and modulated by an RFID reader, multiply a voltage level of the received signal to have a predetermined voltage, and output the signal having a high voltage level. Thus, the signal received by the voltage multiplier 110 may be a signal which has been obtained by coding a digital signal and modulated to be transmitted. A signal output from the demodulation apparatus 100 may be a digital signal restored through demodulation or a coded digital signal.

Also, the voltage multiplier 111 may perform voltage multiplication only when a signal having a relatively low peak voltage level, in comparison to a particular voltage level, is input. In this case, electric power consumption with respect to voltage multiplication can be reduced. In particular, when a voltage level of a received signal is lower than a particular voltage level, the voltage multiplier 111 performs a multiplication operation according to a degree of low voltage level to increase a voltage level of an output signal, and in case of a signal having a voltage level higher than the particular voltage level, the voltage multiplier 111 determines a degree of the high voltage level of signal to lower the voltage level.

The voltage multiplier 111 provides the voltage-multiplied external signal to the shunt RC circuit section 112.

Meanwhile, the shunt RC circuit section 112 disposed in the rear stage of the voltage multiplier 111 determines an RC time constant.

In this manner, the voltage multiplier 111 and the shunt RC circuit section 112, constituting the envelope detecting unit 110, receive the ASK-modulated signal, multiply the received ASK-modulated signal, receive the voltage-multiplied signal, and detect an envelope signal.

The envelope signal detected through the envelope detecting unit 110 may be delivered to a first input terminal of the comparator 130.

Meanwhile, although not shown, a low pass filter (abbreviated as LPF hereinafter) may be disposed in a rear stage of the envelope detecting unit 110 to perform filtering on the detected envelope signal. For example, the LPF may perform an operation of removing high frequency noise on the voltage-multiplied RFID modulation signal. The signal without high frequency noise may be input to the comparator 130.

The reference voltage generating unit 120 receives the envelope signal detected through the envelope detecting unit 110 or the envelope signal filtered through the LPF, and generates a reference voltage to be input to the comparator 130 on the basis of the received envelope signal.

In this case, the reference voltage generated by the reference voltage generating unit 120 may be provided to a second input terminal of the comparator 130.

Also, the reference voltage generating unit 120 may adjust the voltage of the envelope signal through a voltage divider and filter the voltage-adjusted signal to generate a reference voltage having a stable intermediate voltage level. This will be described in detail below.

The comparator 130 compares the envelope signal received through the first input terminal thereof with the reference voltage received through the second input terminal thereof and generates a pulse signal based on the comparison results. The pulse signal may be delivered as a demodulated signal to the outside or to a different device within the RFID tag.

Upon comparing the envelope signal with the reference voltage, when the voltage level of the envelope signal is higher than that of the reference voltage, the comparator 130 may output a predetermined positive (+) voltage, and when the voltage level of the envelope signal is lower than that of the reference voltage, the comparator 130 may output a predetermined negative (-) voltage, whereby the comparator 130 generates a pulse signal having a square wave and outputs the generated pulse signal.

Thus, the signal output from the comparator 130 may be a demodulated digital signal and include a signal transmitted after being coded in the RFID reader.

Also, in order to generate the pulse signal, the comparator 130 comprises a hysteresis comparator to generate a square wave through comparison based on a positive feedback scheme.

The input signal adjusting unit 140 may adjust a magnitude of the envelope signal input to the first input terminal of the comparator 130 after being detected by the envelope detecting unit 110.

In this case, the input signal adjusting unit 140 may be a switch which selectively performs a switching operation.

Also, the input signal adjusting unit 140 may be configured as a transistor serving as a switch, and may be controlled by the reference voltage negatively fed back from the second input terminal of the comparator 130 to which the reference voltage is input.

For example, when the reference voltage input to the second input terminal of the comparator 130 is lower than a predetermined operational voltage, the input signal adjusting unit 140 performs an opening operation. In this case, when the reference voltage input to the second input terminal of the comparator 130 is increased to be higher than the predetermined operational voltage, the input signal adjusting unit 140 is automatically biased by the reference voltage higher than the operational voltage to come to a closed state.

Namely, the voltage of the input ASK-modulated signal is multiplied by the envelope detecting unit 110.

Thus, when the voltage level of the input ASK-modulated signal is high, an envelope of the corresponding signal may follow an accurate square shape, but since the magnitude of a data signal applied as an input to the comparator 130 is too great to generate a reference voltage level.

Thus, in an embodiment of the present invention, the magnitude of the envelope signal input to the comparator 130 is adjusted on the basis of the reference voltage level, whereby although a signal having a high voltage level is applied, a normal demodulation operation is performed thereon.

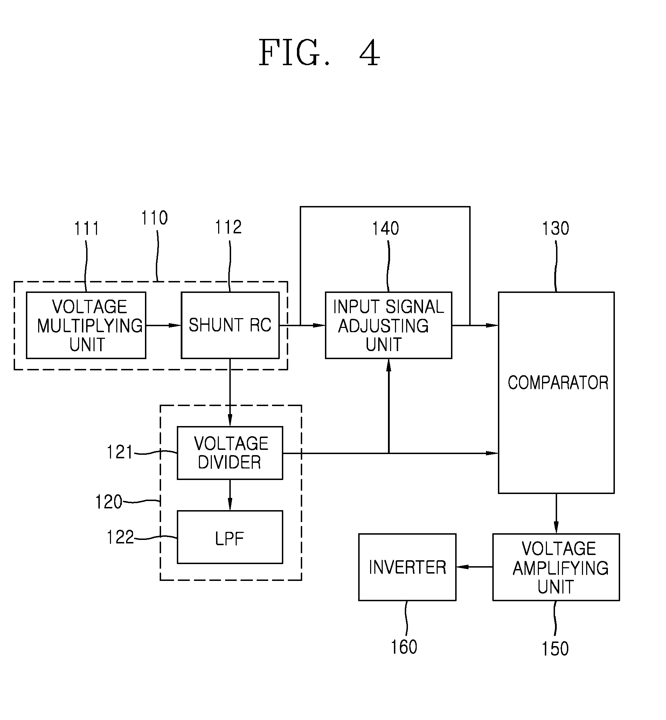

FIG. 4 is a block diagram of the demodulation apparatus 100 according to another embodiment of the present invention.

Referring to FIG. 4, as mentioned above, the demodulation apparatus 100 according to another embodiment of the present invention comprises the envelope detecting unit 110 including the voltage multiplier 111 and the shunt RC circuit section 112 receiving a modulated signal and performing voltage multiplication thereon, the reference voltage generating unit 120 including a voltage divider and a low pass filter (that is LPF) 122, the comparator 130, the input signal adjusting unit 140, a voltage amplifying unit 150 amplifying a voltage of a pulse signal output through the comparator 130, and an inverter 160 performing voltage level shifting.

First, the voltage multiplier 111 receives a modulated signal from the outside and multiplies a voltage thereof, as described above, In this case, in order to more effectively perform voltage multiplication, the voltage multiplier 111 comprises a plurality of voltage multipliers. In particular, the voltage multiplier 111 may multiply the received signal to have a first voltage, and multiplies the corresponding signal to have a second voltage again on the basis of the first voltage, thus multiplying the signal to have a higher voltage level. In this case, the signal may be multiplied to a high voltage with a small amount of electric power, having an effect of reducing electric power consumption.

Meanwhile, in the envelope detecting unit 110, the signal multiplied by the voltage multiplier 111 is delivered to the shunt RC circuit section 112 in the envelope detecting unit 110 .

The envelope detecting unit 110 removes a high frequency carrier signal from the voltage-multiplied signal to detect an envelope.

Meanwhile, the envelope detecting unit 110 may further include not shown low pass filter to perform low pass filtering on the detected envelope. The low pass filter may transform the envelope signal detected by the envelope detecting unit 110 into a signal having a waveform approximate to a sine waveform.

The reference voltage generating unit 120 generates a reference voltage on the basis of the detected envelope signal. The generated reference voltage may be input to the comparator 130 and used to generate a pulse signal. Also, the reference voltage generating unit 120 comprises a voltage divider 121 and an LPF 122 to generate a stable and accurate reference voltage.

The voltage divider 121 may generate a primary reference voltage on the basis of the detected envelope signal. The voltage divider 121 may perform a voltage dividing on the detected envelope signal to obtain an intermediate voltage of the detected envelope signal. Also, the voltage divider 121 may output the obtained intermediate voltage as the foregoing primary reference voltage.

The LPF 122 may perform low pass filtering on the primary reference voltage output from the voltage divider 121 to obtain a reference voltage and output the obtained reference voltage to the comparator 130.

Here, low pass filtering aimed at obtaining a reference voltage may be performed twice. In this manner, by performing double low pass filtering, the reference voltage generating unit 120 may effectively remove a frequency component in the reference voltage.

Also, even when a peak voltage level of the envelope signal is high or low, the reference voltage generating unit 120 may be able to obtain a stable reference voltage waveform through the voltage divider 121 and the LPF 122, significantly enhancing demodulation efficiency.

Meanwhile, the comparator 130 receives the envelope signal detected from the envelope detecting unit 110 , and receives the reference voltage from the LPF122. In this case, as described above, the comparator 130 may receive the envelope signal through the first input terminal thereof and the reference voltage through the second input terminal thereof, compare them, and output a pulse signal corresponding to a digital signal demodulated according to the comparison results.

Also, the comparator 130 comprises a differential input terminal and a hysteresis comparator connected to the differential input terminal. Thus, the first input terminal and the second input terminal of the comparator 130 may configure the differential input terminal and the differential input terminal may be connected to the hysteresis comparator. The hysteresis comparator may have a positive feedback type latch configuration and comprises a two-stage differential amplifier. The hysteresis comparator may be immediately saturated according to a difference between the envelope signal and the reference voltage input from the first input terminal and the second input terminal, respectively, to thus generate a pulse signal and output the generated pulse signal.

The input signal adjusting unit 140 adjusts a magnitude of the envelope signal input to the first input terminal of the comparator 130 after being detected by the envelope detecting unit 110.

Here, the input signal adjusting unit 140 may be a switch selectively performing a switching operation.

Also, the input signal adjusting unit 140 may be configured as a transistor serving as a switch, and may be controlled to be negatively fed back from the second input terminal to which the reference voltage is input.

For example, when the reference voltage input to the second input terminal of the comparator 130 is lower than a predetermined operational voltage, the input signal adjusting unit 140 turns to an open state. In this case, when the reference voltage input to the second input terminal of the comparator 130 is increased to be higher than the predetermined operational voltage, the input signal adjusting unit 140 is automatically biased by the reference voltage higher than the operational voltage to turn to a closed state.

Namely, the voltage of the input ASK-modulated signal is multiplied by the envelope detecting unit 110.

Thus, when the voltage level of the input ASK-modulated signal is high, an envelope of the corresponding signal may follow an accurate square shape, but since the magnitude of the applied as an input to the comparator 130 is too great to generate a reference voltage level.

Thus, in an embodiment of the present invention, the magnitude of the envelope signal input to the comparator 130 is adjusted on the basis of the reference voltage level, whereby although a signal having a high voltage level is applied, a normal demodulation operation is performed thereon.

The pulse signal output from the comparator 130 is delivered to the voltage amplifying unit 150, and the voltage amplifying unit 150 may amplify the pulse signal output from the comparator 130 such that it has a voltage level appropriate to be output.

The inverter 160 performs voltage shifting on the voltage-amplified pulse signal. The voltage-shifted pulse signal comprises a demodulated digital signal, and the demodulated digital signal may be a signal which has been coded according to an RFID communication scheme.

As described above, the demodulation apparatus 100 according to an embodiment of the present invention may effectively multiply a voltage through two-stage voltage multiplication. In addition, the demodulation apparatus 100 may perform stable and accurate signal demodulation by adjusting a magnitude of the envelope signal applied to the comparator 130 according to the reference voltage generated on the basis of the envelope signal.

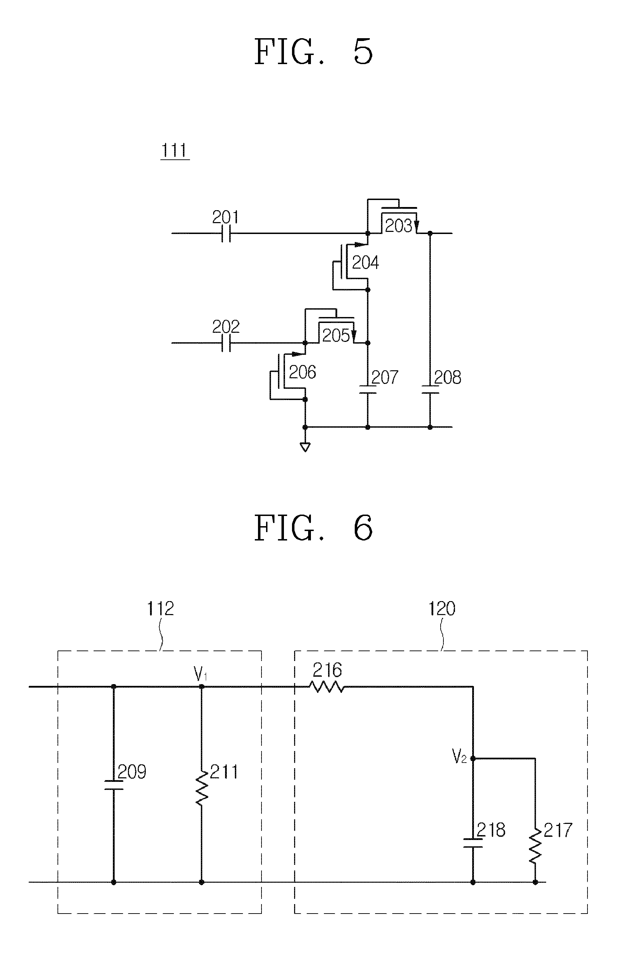

FIG. 5 is a circuit diagram illustrating a configuration of the voltage multiplier 111 according to an embodiment of the present invention illustrated in FIG. 3 or 4.

Referring to FIG. 5, the voltage multiplier 111 according to an embodiment of the present invention comprises a plurality of first capacitors 201 and 202, a plurality of first NMOS transistors 203, 204, 205, and 206, and shunt capacitors 207 and 208.

The plurality of capacitors 201 and 202 may be connected to a receiving terminal RFin (not shown but can refer to Fig. 1) in series to receive a high frequency signal from the outside.

The first NMOS transistors 203 and 204 may be paired with the first capacitor 201, and the first NMOS transistors 205 and 206 may be paired with the first capacitor 202. Also, the shunt capacitors 207 and 208 may be connected to the first NMOS transistors of each pair.

In this manner, the voltage multiplier 111 may perform voltage multiplication at various stages through the plurality of shunt capacitors 207 and 208 and the plurality of first NMOS transistors. For example, in FIG. 5, in the voltage multiplier 111, the plurality of first NMOS transistors 205 and 206 and 203 and 204 having a low threshold voltage level are diode-connected, and the shunt capacitors 207 and 208 are connected to each diode-connection, thereby performing two-stage voltage multiplication including first voltage multiplication and second voltage multiplication.

FIG. 6 is a circuit diagram illustrating detail configurations of the shunt RC circuit section 112 and the reference voltage generating unit 120 according to an embodiment of the present invention illustrated in FIG. 3 or 4.

The shunt RC circuit section 112 includes a resistor 211 and a capacitor 209 connected in parallel to the first NMOS transistor 203 connected to an output terminal of the voltage multiplying unit 111. In an embodiment of the present invention, a signal received by the voltage multiplying unit 111 may be an ASK-modulated signal. Thus, the shunt RC circuit section 112 may remove a high frequency signal by using the resistor 211 and the capacitor 209 from the voltage-multiplied signal to obtain only a low frequency signal, thus detecting an envelope corresponding to the modulated signal.

Also, the shunt RC circuit section 112 may filter the detected envelope signal to output a filtered signal. Here, it is illustrated that a voltage of the filtered output signal is V1.

Since first filtering is performed on the envelope by the shunt RC circuit section 112, an wave of the envelope may have a curve close to a sine wave, and thus, the comparator 130 may generate an accurate pulse signal. The filtered signal may be input to the first input terminal of the comparator 130.

The reference voltage generating unit 120 may generate the reference voltage V2 on the basis of the filtered envelope signal V1 and transmits it to the second input terminal of the comparator 130.

The reference voltage generating unit 120 comprises a voltage dividing unit and an LPF. In FIG. 6, a circuit including a mixture of a voltage dividing unit and an LPF is illustrated, but the voltage dividing unit and the LPF may be separately provided according to an embodiment. As illustrated in FIG. 6, the reference voltage generating unit 120 may perform low pass filtering on the reference voltage V2 through resistors 216 and 217 and a capacitor 218, and also serve to divide voltage into V1 and V2 according to the resistors 216 and 217 and impedance of the LPF. Thus, the reference voltage generating unit 120 may be configured as an LPF including a voltage dividing unit. In this manner, the low pass-filtered reference voltage V2 may be input as a reference voltage of the second input terminal of the comparator 130, to allow the comparator 130 to compare the filtered envelope signal with the reference voltage V2 and output a corresponding pulse signal.

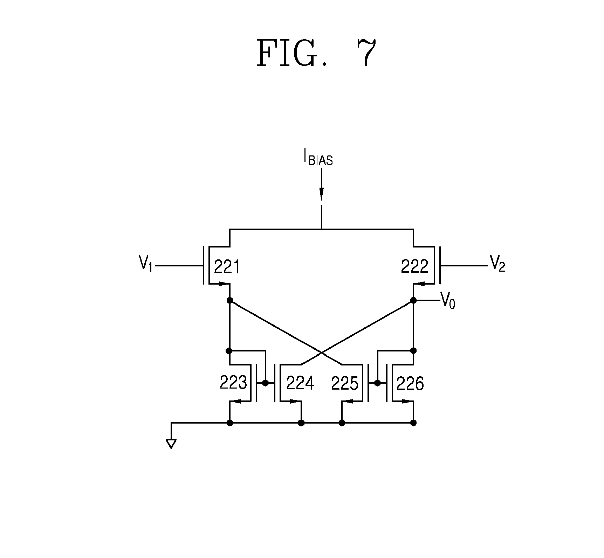

FIG. 7 is a circuit diagram illustrating a detail configuration of the comparator 130 according to an embodiment of the present invention illustrated in FIG. 3 or 4.

Referring to FIG. 7, the comparator 130 comprises a first input terminal 221, a second input terminal 222, and a plurality of NMOS transistors 223, 224, 225, and 226 configuring a hysteresis circuit.

The first input terminal 221 and the second input terminal 222 may be a PMOS transistor, respectively, and comprises a differential input terminal to receive the frequency signal V1 output from the envelope detecting unit 110 by a bias current lbias and the reference voltage V2 output from the reference voltage generating unit 120 and deliver the frequency signal V1 and the reference voltage V2 to the hysteresis circuit.

As illustrated in FIG. 7, the hysteresis circuit comprises the plurality of NMOS transistors 223, 224, 225, and 226 cross-linked to the first input terminal 221 and the second input terminal 222. The respective transistors configure the hysteresis circuit for comparing voltages between the differential input terminal and a ground. Also, the hysteresis circuit may be based on positive feedback, and comprises a Schmitt trigger circuit. Also, as illustrated in FIG. 7, a hysteresis range of the hysteresis circuit may be determined by a latch configuration.

According to the configuration of the comparator 130, the comparator 130 may compare the input voltage V1 and the reference voltage V2, and when the input voltage V1 is greater or smaller than the reference voltage V2, outputs from the comparator 130 may be saturated negatively or positively by the positive feedback circuit to generate a pulse signal V0 having a square wave. The pulse signal V0 may be a demodulated digital signal, which is output to the outside or may be voltage-amplified and level-shifted so as to be decoded.

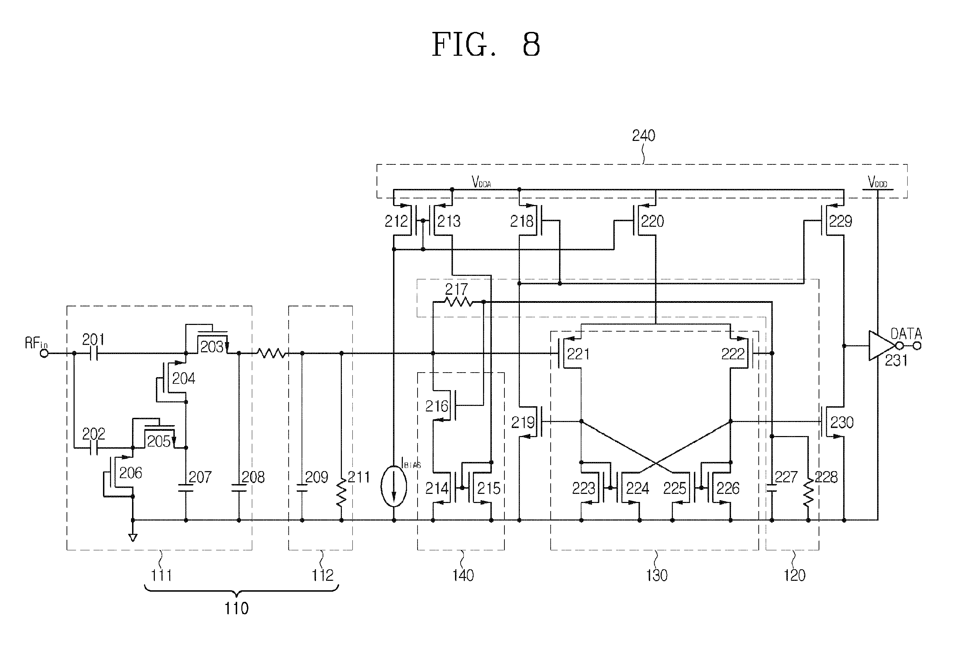

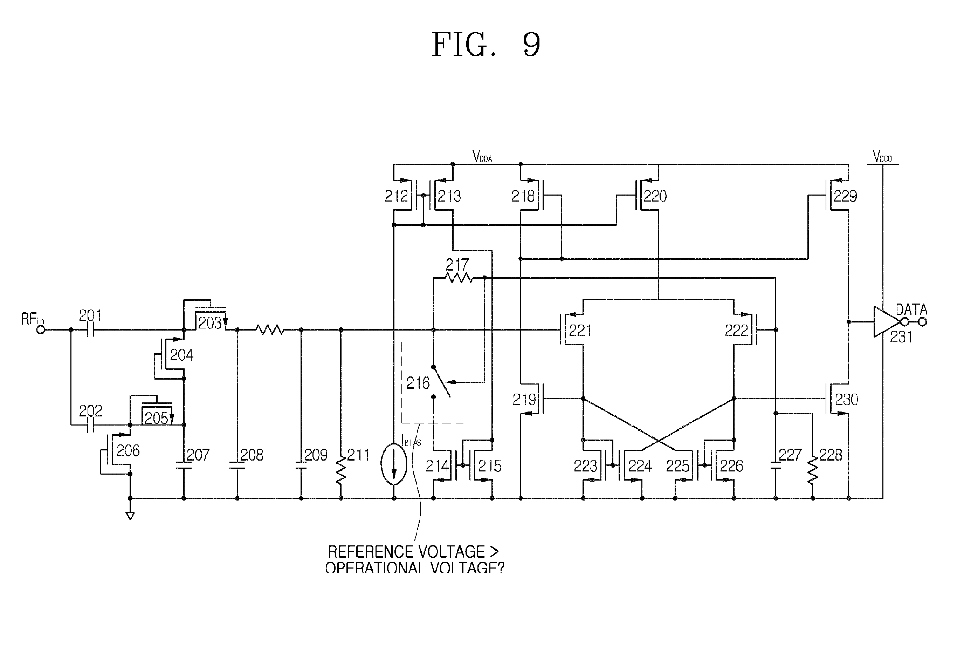

FIGS. 8 and 9 are circuit diagrams specifically illustrating an overall configuration of the demodulation apparatus 100 according to an embodiment of the present invention.

Referring to FIG. 8, the demodulation apparatus 100 according to an embodiment of the present invention comprises a voltage multiplying unit 111, the shunt RC circuit section 112, the reference voltage generating unit 120, the comparator 130, the input signal adjusting unit 140, and a power supply unit 240.

The voltage multiplying unit 111 comprises the plurality of first capacitors 201 and 202, the plurality of first NMOS transistors 203, 204, 205, and 206, and the shunt capacitors 207 and 208, and output a voltage-multiplied frequency signal from an input signal RFin.

The shunt RC circuit section 112 comprises the resistor 211 and the capacitor 209 connected in parallel to the first NMOS transistor 203 connected to an output terminal of the voltage multiplying unit 111, and remove a high frequency signal from the voltage-multiplied signal to detect an envelope.

Also, the shunt RC circuit section 112 may perform low pass filtering on the detected envelope to output a curved waveform close to a sine wave and deliver the same to the first input terminal 221 of the comparator 130.

Meanwhile, the reference voltage generating unit 120 generates a reference voltage on the basis of the signal detected by the envelope detecting unit 110 by using the LPF including a voltage dividing unit. The reference voltage may be input to the second input terminal 222 of the comparator 130 and used as a comparison reference voltage.

Meanwhile, the power supply unit 240 supplies overall electric power for a basic operation of the circuit. It may be configured that the current source IBIAS and the plurality of transistors 212, 213, 214, 215, 218, and 220 for current mirroring constitute a current mirroring circuit, and the current lbias for driving the comparator 130 is input to the comparator 130.

As described above, the comparator 130 comprises the first input terminal 221, the second input terminal 222, and the plurality of NMOS transistors 223, 224, 225, and 226 constituting a hysteresis circuit. The comparator 130 may compare a voltage input from the first LPF 103 with the voltage input from the reference voltage generating unit 104 to generate and output a pulse signal as a demodulated digital signal.

Namely, two PMOS transistors 221 and 222 of the comparator 130 form differential input terminals, and PMOS transistors 212, 213, 218, and 220 performing current mirroring upon receiving a current from the current source IBIAS are disposed between the comparator 130 and a power source VDDA. NMOS transistors having a cross-couple structure configured between the differential input terminals and a ground generate hysteresis of the comparator 130.

Meanwhile, a plurality of PMOS transistors 229 and 230 used for compensating a voltage level are connected to output terminals of the comparator 130 to compensate a voltage of the output pulse signal. Also, a level shift inverter 231 performs voltage level shifting on the voltage-compensated pulse signal to output a signal having an accurate level.

A resistance component value of the NMOS transistor 214 connected to an input terminal of the comparator 130 is determined by the NMOS transistor 215 connected in cascade to the current-mirrored PMOS transistor 213. The NMOS transistor 214 is connected to the input terminal of the comparator 130 according to whether the NMOS transistor 216 performs a switching operation.

The NMOS transistor 216 serving as a switch is negatively fed back from the reference voltage differential input terminal (the second input terminal) so as to be controlled.

Namely, when the NMOS transistor 216 is closed, the NMOS transistor 214 is connected to the comparator 130, and when the NMOS transistor 216 is opened, the NMOS transistor 214 may not be connected to the comparator 130.

The foregoing demodulation apparatus 100 will be described as follows.

When an ASK-modulated signal is input, an envelope of the signal is detected by the envelope detecting unit 110 including the voltage multiplying unit 111 and the shunt RC circuit section 112. In this case, a magnitude of an output voltage of the envelope and a time at which the data is lowered from a high level to a low level are determined according to an RC time constant. At this time, as the stage number of the voltage multiplying unit 111 is increased, an input signal having a lower voltage level may be demodulated, but in a case in which a signal having a high level of electric power is applied, since the voltage with respect to an envelope is remarkably increased, making it difficult to normally demodulate the signal.

Thus, two stages are desirable for the voltage multiplying unit 111 as illustrated in FIG. 5, and an RC time constant is adjusted by using the capacitor 209 and the resistor 211 at the rear stage.

However, in a case in which a signal having a remarkably high voltage level as an input signal is applied, an envelope of the signal may follow a normal sine wave similarly, but a magnitude of a data signal applied as an input to the comparator 130 is excessively increased to be too great to generate a normal reference voltage level.

Thus, in an embodiment of the present invention, the NMOS transistor 216 is used as a switch, and the NMOS transistors 214 and 215 and the PMOS transistors 212 and 213 are used as current sources.

In addition, when the input signal having a high voltage level is applied, the NMOS transistor 216 is closed to reduce a magnitude of the signal applied to the comparator 130.

Namely, when the NMOS transistor 216 is opened, reflection loss is small from a perspective of an input of the comparator 130, and when the NMOS transistor 216 is closed, reflection loss is great.

A switched state of the NMOS transistor 216 is determined by the reference voltage automatically biased after being negatively fed back from the differential input terminal to which the reference voltage is applied. Thus, when a signal having a low voltage level is applied, the NMOS transistor 216 is automatically opened, and when a signal having a high voltage level is applied, the NMOS transistor 216 is automatically closed.

The data signal whose envelope has been detected is applied to the first input terminal of the comparator 130, the reference voltage having a DC component is input to the second input terminal of the comparator 130 through the LPF 122 including a voltage divider, and the generated voltage level serves to automatically switch the NMOS transistor 216.

Also, the comparator 130 having a positive feedback scheme including hysteresis may have a hysteresis range defined by a latch structure, and may have a two-stage differential amplifier structure. The comparator 130 may output a signal having an accurate level due to the inverter serving as a level shift.

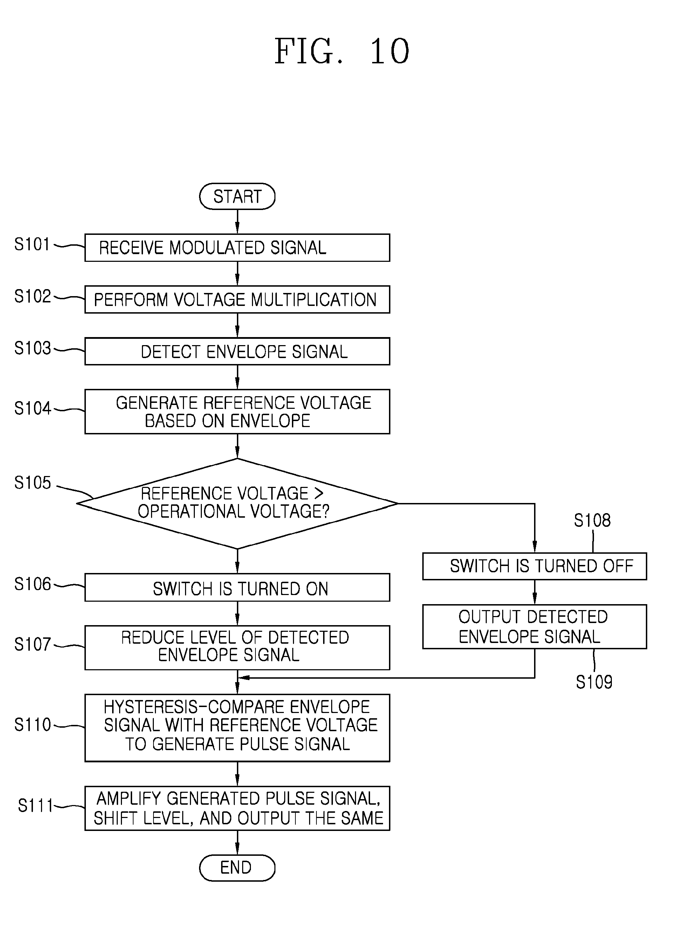

FIG. 10 is a flow chart illustrating a method for operating the demodulation apparatus 100 according to an embodiment of the present invention.

Referring to FIG. 10, the voltage multiplying unit 111 receives a modulated frequency signal from the outside (step 101). The received signal may be an ASK-modulated frequency signal and may be a signal received from an RFID reader. In this case, the demodulation apparatus 100 according to an embodiment of the present invention may be included in a passive or active RFID tag. The RFID reader may decode the digital signal to be transmitted to RFID, modulates the decoded signal on the basis of a predetermined frequency signal, and transmit the same to an RFID tag including the demodulation apparatus 100. Thus, the voltage multiplying unit 111 may receive the modulated and decoded digital signal.

The voltage multiplying unit 111 performs voltage multiplication on the received signal to have a predetermined voltage level (step 102). Since the received signal may have a very low voltage level according to a distance, the voltage multiplying unit 111 may multiply the voltage to have a predetermined voltage level. Also, the voltage multiplying unit 111 may perform voltage multiplication by defining a reference voltage as necessary, and may perform two-stage voltage multiplication from a first voltage to a second voltage to enhance multiplication efficiency as described above.

Meanwhile, the shunt RC circuit section 112 detects an envelope signal on the basis of the voltage-multiplied signal (step 103).

Thereafter, the reference voltage generating unit 120 performs voltage dividing on the detected envelope signal to generate a reference voltage (step 104). The reference voltage generating unit 120 performs low pass filtering on the generated reference voltage by using the LPF. Since the generated reference voltage is filtered, although a signal has an excessively high reference voltage, a stable operation can be guaranteed.

In this case, the generated reference voltage is negatively fed back and applied to the input signal adjusting unit 140. Upon receiving the reference voltage, the input signal adjusting unit 140 is automatically changed in state by the reference voltage.

Namely, first, whether the reference voltage is higher than a predetermined operational voltage (step 105).

Thereafter, when the reference voltage is higher than the predetermined operational voltage according to the determination result (step 105), the input signal adjusting unit 140 turns to an ON state (step 106).

As the input signal adjusting unit 140 performs the ON operation, a magnitude of the detected envelope signal is reduced (step 107).

Meanwhile, when reference voltage is lower than the predetermined operational voltage, the input signal adjusting unit 140 turns to an OFF state (step 108).

Accordingly, the detected envelope signal is immediately output to the comparator 130 without adjusting a level thereof (step 109).

Thereafter, the comparator 130 compares the envelope signal with the reference voltage through the hysteresis positive feedback circuit, and generates a pulse signal as a result (step 110). The comparator 130 has the configuration and performs operations as described above, and the output pulse signal comprises a demodulated digital signal.

The voltage amplifier 150 amplifies a voltage of the output pulse signal to compensate the pulse signal, and the inverter 160 shifts the compensated pulse signal to have a voltage having an appropriate level, and outputs the same (step 111). An external device connected to an output terminal of the demodulation apparatus 100 may receive the demodulated digital pulse signal having an appropriate voltage level. Also, the external device may decode the demodulated digital pulse signal to determine a meaning of the signal transmitted from the outside.

According to the embodiment of the present invention as described above, after the reference voltage is generated, a voltage level thereof is negatively fed back to automatically control the switching element of the input terminal, an ASK-modulated signal having various modulation indices ranging from 0 to 100% and a wide range of voltage levels can be normally demodulated.

Also, according to an embodiment of the present invention, even when a signal having a low voltage level is applied, it may be demodulated, and even when a signal having a high voltage level is applied, a signal having a high voltage level is not generated in the input terminal of the comparator, those signals may be demodulated due to the performance of the comparator. Thus, the demodulation apparatus according to an embodiment of the present invention can be applicable to various systems (passive and active RFID tags, a wireless power transmission system, a passive bio-system, and the like), regardless of a voltage level of an input signal.

In the embodiments of the present invention, the method for operating a demodulation apparatus according to an embedment of the present invention as described above may be produced as a program executable in a computer and stored in a computer-readable recording medium. The computer-readable recording medium comprises a ROM, a RAM, a CD-ROM, a magnetic tape, a floppy disk, an optical data storage device, and the like. The computer-readable medium also includes implementations in the form of carrier waves or signals (e.g., transmission via the Internet).

The computer-readable recording medium may also be distributed to computer systems connected via a network so that the computer-readable codes are stored and executed in a distributed fashion. Functional programs, codes, and code segments for implementing the method may be easily inferred by programmers in the art to which the present invention pertains.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A demodulation apparatus, **characterized in that** the demodulation apparatus comprising:
an envelope detecting unit (110) configured to receive a signal from the outside and detect an envelope signal from the received signal;
a reference voltage generating unit (120) configured to generate a reference voltage on the basis of the detected envelope signal;
a comparator (130) configured to output a pulse signal on the basis of the envelope signal detected by the envelope detecting unit (110) and the reference voltage generated by the reference voltage generating unit (120); and
an input signal adjusting unit (140) connected with an envelope signal input terminal of the comparator (130) to selectively adjust a magnitude of the envelope signal input to the comparator (130),
wherein the envelope signal detecting unit (110) comprises: a voltage multiplying unit (111) configured to multiply a voltage of the received signal; and a shunt resistor capacitor (112) connected to an output terminal of the voltage multiplying unit to determine an time constant.

2. The demodulation apparatus of claim 1, wherein the input signal adjusting unit (140) comprises a switch (216) whose switching state is selectively changed to adjust a magnitude of the envelope signal.

3. The demodulation apparatus of claim 2, wherein the switch (216) is automatically biased according to a magnitude of the reference voltage input to the comparator (130) to have a changed switching state.

4. The demodulation apparatus of claim 2, wherein the switch (216) is configured that when the reference voltage input to the comparator (130) is higher than a predetermined operational voltage, the switch (216) is closed, and when the reference voltage input to the comparator (130) is lower than the predetermined operational voltage, the switch (216) is opened.

5. The demodulation apparatus according to any one of claims 1-4, further comprising:
a plurality of transistors (212, 213, 214, 215, 218, 220) for current mirroring and disposed in the envelope signal input terminal of the comparator (130),
wherein the plurality of transistors (212, 213, 214, 215, 218, 220) are selectively connected to the envelope signal input terminal of the comparator (130) according to a switching state of the switch.

6. The demodulation apparatus according to any one of claims 1-5, wherein the comparator (130) comprises:
a pair of differential input terminals (221, 222) configured to receive the reference voltage and the envelope signal, respectively; and
a hysteresis circuit including a plurality of transistors (223, 224, 225, 226) cross-linked to the pair of differential input terminals (221, 222).

7. The demodulation apparatus of claim 6, wherein the pair of differential input terminals (221, 222) comprise:
a first input terminal (221) configured to receive the envelop signal; and
a second input terminal (222) configured to receive the reference voltage,
wherein the input signal adjusting unit (140) is disposed between the envelope signal detecting unit (110) and the first input terminal (221) of the comparator (130).

8. The demodulation apparatus according to any one of claims 1-7, wherein the voltage multiplying unit (111) comprises:
a first voltage multiplying unit (201, 203, 204, 208) configured to receive the Amplitude Shift Keying-modulated signal and multiply the Amplitude Shift Keying-modulated signal to have a first voltage; and
a second voltage multiplying unit (202, 205, 206, 207) configured to multiply the signal, which has been multiplied to have the first voltage, to have a second voltage, and output the same.

9. The demodulation apparatus according to any one of claims 1-8, wherein the voltage multiplying unit (111) comprises:
at least a pair of capacitors (201, 202) connected in series mutually to receive the Amplitude Shift Keying-modulated signal;
a plurality of N-channel Metal Oxide Semiconductor transistors (203, 204, 205, 206) connected to the at least one capacitor (201, 202); and
at least one shunt capacitor (207, 208) connected to the plurality of NMOS transistors (203, 204, 205, 206).

10. The demodulation apparatus according to any one of claims 1-9, wherein the reference voltage generating unit (120) comprises:
a voltage divider (121) configured to divide the voltage of the detected envelope signal to generate a reference voltage signal; and
a low pass filter (122) configured to filter the generated reference voltage signal and output a reference voltage to be input to the comparator (130).

11. The demodulation apparatus according to any one of claims 1-10, wherein the envelope detecting unit (110) is configured to receive the Amplitude Shift Keying-modulated signal from at least one RFID reader positioned nearby.

12. The demodulation apparatus according to any one of claims 1-11, further comprising:
a voltage amplifying unit (150) configured to amplify a voltage of a pulse signal output from the comparator (130),
wherein the voltage amplifying unit (150) comprises at least one P-channel Metal Oxide Semiconductor transistor (229, 230).

13. The demodulation apparatus according to any one of claims 1-12, further comprising:
a level shift circuit (160, 231) configured to receive the amplified pulse signal from the voltage amplifying unit (150) and adjust a voltage level of the received pulse signal.
